# EUROPEAN PATENT SPECIFICATION

(11) **EP 2 404 487 B1**
(45) Date of publication and mention of the grant of the patent: **22.04.2015**
(21) Application number: 10706879.3
(22) Date of filing: 01.03.2010
(51) Int. Cl.: H05K 3/28, B32B 27/20, B32B 27/34

(54) **MULTILAYER FILM FOR ELECTRONIC CIRCUITRY APPLICATIONS AND METHODS RELATING THERETO**
MEHRSCHICHTFILM FÜR ELEKTRONISCHE SCHALTKREISANWENDUNGEN UND DIESBEZÜGLICHE VERFAHREN
FILM MULTICOUCHE POUR APPLICATIONS À DES CIRCUITS ÉLECTRONIQUES ET PROCÉDÉS CORRESPONDANTS

(30) Priority: 06.03.2009 US 158074 P
(43) Date of publication of application: 11.01.2012
(73) Proprietor: E. I. du Pont de Nemours and Company, Wilmington, DE 19898 (US)
(72) Inventor: CARNEY, Thomas, Edward, Orient Ohio 43146 (US); GONZALEZ, Rosa Irene, Pearland Texas 77584 (US); DUNBAR, Meredith, L., Canal Winchester Ohio 43110 (US); OCHSNER, James, P., Houston Texas 77059 (US)
(74) Representative: Towler, Philip Dean
(86) International application number: PCT/US2010/025756
(87) International publication number: WO 2010/101822

(56) References cited:
- EP-A1- 0 659 553
- EP-A1- 2 072 580
- US-A1- 2005 164 022
- US-A1- 2007 158 869
- US-A1- 2009 022 939
- US-A1- 2009 062 505

## Description

### FIELD OF DISCLOSURE

The field of this disclosure is multilayer polyimide films used in electronic circuitry applications.

### BACKGROUND OF THE DISCLOSURE

Broadly speaking, coverlays are known and are generally used as a barrier film for protecting electronic materials, such as, flexible printed circuit boards, electronic components or integrated circuit package leadframes. *See generally,* U.S. Pat. No. 5,473,118 to Fukutake, et al. Conventional coverlays can protect against a number of unwanted defects, such as, scratching, oxidation and contamination. However, a need persists for increasingly lower cost, higher performing films for electronics applications.

### SUMMARY OF THE INVENTION

Disclosed are multilayer films having:
a first outer layer having a first outer layer polyimide base polymer in an amount from 45 to 98.9 weight % based upon the total weight of the first outer layer, a first outer layer carbon black filler in an amount from 1 to 15 weight % based upon the total weight of the first outer layer, and a first outer layer dielectric filler in an amount from 0.1 to 40 weight % based upon the total weight of the first outer layer;
a core layer having a core layer polyimide base polymer in an amount of at least 95 weight percent based upon the total weight of the core layer; and
a second outer layer having a second outer layer polyimide base polymer in an amount from 45 to 98.9 weight % based upon the total weight of the second outer layer, a second outer layer low conductivity carbon black filler in an amount from 1 to 15 weight % based upon the total weight of the second outer layer, and a second outer layer dielectric filler in an amount from 0.1 to 40 weight % based upon the total weight of the second outer layer.

The first outer layer polyimide base polymer, the core layer polyimide base polymer, and the second outer layer polyimide base polymer can each be the same or different and can each comprise one polyimide polymer or more than one polyimide polymer. Such multilayer films of the present invention can have a thickness within a range from 6 to 200 microns.

Also disclosed are multilayer films having:
a first outer layer having a first outer layer base polymer in an amount from 45 to 98.9 weight % based upon the total weight of the first outer layer, a first outer layer carbon black filler in an amount from 1 to 15 weight % based upon the total weight of the first outer layer, and a first outer layer dielectric filler in an amount from 0.1 to 40 weight % based upon the total weight of the first outer layer;
a core layer having a core layer base polymer in an amount of at least 95 weight percent based upon the total weight of the core layer; and
a second outer layer having a second outer layer base polymer in an amount from 45 to 98.9 weight % based upon the total weight of the second outer layer, a second outer layer low conductivity carbon black filler in an amount from 1 to 15 weight % based upon the total weight of the second outer layer, and a second outer layer dielectric filler in an amount from 0.1 to 40 weight % based upon the total weight of the second outer layer.

The first outer layer base polymer, the core layer base polymer, and the second outer layer base polymer can each be the same or different and each comprise one or more members of the group consisting of: polyesters, liquid crystalline polymers, fluoropolymers, polyetherketones, polyetheretherketones, polyetherketoneketones, polyamides, polyaramides, polysulfonamides and derivatives or combinations thereof. Such multilayer films of the present invention can have a thickness within a range from 6 to 200 microns.

### DESCRIPTION OF THE DRAWING

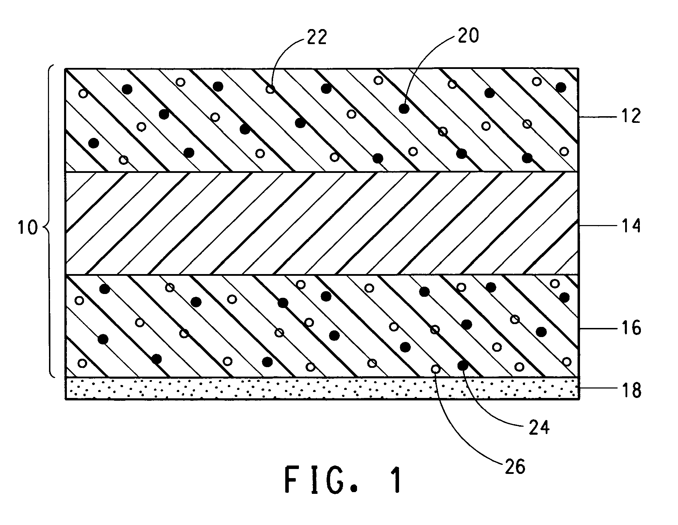

Figure 1 is a cross-sectional perspective view of one embodiment of the present disclosure. The cross-sectional view is of a multilayer film having an optional adhesive layer.

### DETAILED DESCRIPTION OF THE PREFERED EMBODIMENTS

The following description is exemplary and explanatory only and is not restrictive of the invention, as defined in the appended claims.

The term "multilayer film" herein may be used interchangeably with coverlayer(s), cover layer(s) or coverlay(s).

The term "finishing solution" herein denotes a dianyhdride in a polar aprotic solvent which is added to a low molecular weight polyamic acid solution to increase the molecular weight and viscosity of the polyamic acid solution. The dianhydride used is typically the same dianhydride used (or one of the same dianhydrides when more than one is used) to make the polyamic acid.

The term "finished polyamic acid" herein denotes when a low molecular weight polyamic acid is increased to a desired molecular weight and viscosity.

The term "polyimide base polymer" is intended to mean any polymeric material having at least one imide moiety, including polymers, oligomers, prepolymers and the like. Also, polyimide base polymer is not intended to mean only a single type of polyimide polymer, but is intended to also mean blends of different polyimide polymeric materials.

"Dianhydride" as used herein is intended to include precursors, derivatives or analogues thereof, which may not technically be a dianhydride but would nevertheless react with a diamine to form a polyamic acid which could in turn be converted into a polyimide.

"Diamine" as used herein is intended to include precursors, derivatives or analogues thereof, which may not technically be a diamine but would nevertheless react with a dianhydride to form a polyamic acid which could in turn be converted into a polyimide.

The present disclosure is directed to multilayer films for electronic circuitry applications. In one embodiment, Figure 1 illustrates a multilayer film10 with an optional adhesive layer 18. The optional adhesive layer 18 can be used to bond the multilayer film to a circuit board. The multilayer film 10 has a first outer layer 12, a dielectric core layer 14, and a second outer layer 16. First outer layer 12 of the multilayer film 10 has a first outer layer carbon black filler 20, and the second outer layer 16 has a second outer layer low conductivity carbon black 24. The first and second outer layers 12 and 16 also comprise a dielectric filler 22 and 26 (respectively), wherein the dielectric filler of layers 12 and 16 can be the same or different. In some embodiments, either of the two outer layers, 12 and 16, can be bonded directly to the core layer 14, such as by lamination or coextrusion, or adhered to the core layer by means of an adhesive.

The multilayer film 10 has a first outer layer 12 comprising:
i. a first outer layer polyimide base polymer in an amount from 45 to 98.9 weight % based upon the total weight of the first outer layer 12;
ii. a first outer layer carbon black filler 20 which can be virtually any carbon black, e.g., low conductivity carbon black and/or high conductivity carbon black, in an amount from 1 to 15 weight % based upon the total weight of the first outer layer 12;
iii. a first outer layer dielectric filler 22 in an amount from 0.1 to 40 weight % based upon the total weight of the first outer layer 12.

The multilayer film 10 has a core layer 14 comprising a core layer polyimide base polymer. The core layer polyimide base polymer is present in an amount of at least 95 weight percent based upon the total weight of the core layer 14. In one embodiment the core layer 14 is a dielectric layer. The multilayer film 10 has a second outer layer 16 comprising:
i. a second outer layer polyimide base polymer in an amount from 45 to 98.9 weight % based upon the total weight of the second outer layer 16;
ii. a second outer layer low conductivity carbon black filler 24 in an amount from 1 to 15 weight % based upon the total weight of the second outer layer 16;
iii. a second outer layer dielectric filler 26 in an amount from 0.1 to 40 weight % based upon the total weight of the second outer layer 16.
The first outer layer polyimide base polymer, the core layer polyimide base polymer, and the second outer layer polyimide base polymer can each be the same or different and can each comprise one polyimide polymer or more than one polyimide polymer.

In one embodiment, the multilayer film 10 has a thickness in a range from 6 to 50 microns.

In some embodiments, a black matte appearance is integral to the multilayer film, and the resulting multilayer film can be relatively thin, have advantageous crack and scratch resistance, have advantageous adhesion, have advantageous flex endurance and also have an advantageous flammability rating (e.g., V-0).

The first outer layer 12 of the multilayer film 10 is intended to be the outermost layer when the multilayer film 10 is applied to a circuit board, and therefore, the second outer layer 16 is intended to be closest to the circuit board, when the multilayer film 10 of this disclosure is applied or bonded to a circuit board. The first outer layer 12 comprises a first outer layer polyimide base polymer present in a range between and optionally including any two of the following weight percentages: 45, 50, 55, 60, 65, 70, 75, 80, 85, 90, 95 and 98.9 weight % based on the total weight of the first outer layer 12. Polyimides of the present disclosure provide good thermal, dimensional and physical properties. In some embodiments, the first outer layer polyimide base polymer is derived from at least one aromatic dianhydride and/or at least one aromatic diamine.

In one embodiment, the first outer layer polyimide base polymer and the second outer layer polyimide base polymer are the same or different and are each derived from one or more aromatic dianhydrides, such as:
1. 2,2-bis(3,4-dicarboxyphenyl) hexafluoropropane;
2. 2,3,6,7-naphthalene tetracarboxylic dianhydride;
3. 3,3',4,4'-biphenyl tetracarboxylic dianhydride;
4. 1,2,5,6-naphthalene tetracarboxylic dianhydride;
5. 2,2',3,3'-biphenyl tetracarboxylic dianhydride;
6. 3,3',4,4'-benzophenone tetracarboxylic dianhydride;
7. 2,2-bis(3,4-dicarboxyphenyl) propane dianhydride;
8. bis(3,4-dicarboxyphenyl) sulfone dianhydride;
9. 3,4,9,10-perylene tetracarboxylic dianhydride;
10. bis(3,4-dicarboxyphenyl) propane dianhydride;
11. 1,1-bis(2,3-dicarboxyphenyl) ethane dianhydride;
12. 1,1-bis(3,4-dicarboxyphenyl) ethane dianhydride;
13. bis(2,3-dicarboxyphenyl) methane dianhydride;
14. bis(3,4-dicarboxyphenyl) methane dianhydride;
15. 4,4'-oxydiphthalic dianhydride;
16. bis(3,4-dicarboxyphenyl) sulfone dianhydride; and
17. mixtures thereof.

In another embodiment, the first outer layer polyimide base polymer and/or the second outer layer polyimide base polymer is/are optionally derived from one or more aliphatic dianhydrides, such as:
1. cyclobutane dianhydride,
2. [1S*,5R*,6S*]-3-oxabicyclo[3.2.1]octane-2,4-dione-6-spiro-3-(tetrahydrofuran-2,5-dione); and
3. mixtures thereof.

Suitable diamines for use in synthesizing the first outer layer polyimide base polymer and/or the second outer layer polyimide base polymer of the present disclosure include aromatic diamines, aliphatic diamines and mixtures thereof. Examples of aromatic diamines include:
1. 4,4'-diaminodiphenyl propane;
2. 4,4'-diamino diphenyl methane;
3. benzidine;
4. 3,3'-dichlorobenzidine;
5. 4,4'-diamino diphenyl sulfide;
6. 3,3'-diamino diphenyl sulfone;
7. 4,4'-diamino diphenyl sulfone;
8. 1,5-diamino naphthalene;
9. 4,4'-diamino diphenyl diethylsilane;
10. 4,4'-diamino diphenysilane;
11. 4,4'-diamino diphenyl ethyl phosphine oxide;
12. 4,4'-diamino diphenyl N-methyl amine;
13. 4,4'-diamino diphenyl N-phenyl amine;
14. 1,4-diaminobenzene (p-phenylene diamine);
15. 1,3-diaminobenzene;
16. 1,2-diaminobenzene;
17. 1,3-bis-(4-aminophenoxy) benzene;
18. 3,4' diamino diphenyl ether;
19. 2,2'-bis(trifluoromethyl) benzidene;
20. 4,4'-diaminobiphenyl;
21. 9,9'-bis(4-amino)fluorine; and
mixtures thereof.

Examples of suitable aliphatic diamines include:
1. hexamethylene diamine,
2. dodecane diamine,
3. cyclohexane diamine, and
4. mixtures thereof.

In another embodiment, the first outer layer polyimide base polymer and/or the second outer layer polyimide base polymer is/are derived from pyromellitic dianhydride and 4,4'-oxydianiline. In one embodiment, the first outer layer polyimide base polymer and/or the second outer layer polyimide base polymer is/are derived from any of the above diamines and dianhydrides. In one embodiment, the first outer layer polyimide base polymer and/or the second outer layer polyimide base polymer is/are derived from 15 to 85 mole % of biphenyltetracarboxylic dianhydride, 15 to 85 mole % pyromellitic dianhydride, 30 to 100 mole % p-phenylenediamine and 0 to 70 mole % of 4,4'-diaminodiphenyl ether. Such copolyimides are further described in U.S. Pat. No. 4,778,872.

In one embodiment, the polyimide dianhydride component (of the first outer layer polyimide base polymer and/or the second outer layer polyimide base polymer) is pyromellitic dianhydride ("PMDA") and the polyimide diamine component (of the first outer layer polyimide base polymer and/or the second outer layer polyimide base polymer) is a combination of 4,4'-oxydianiline ("4,4 ODA") and p-phenylenediamine ("PPD"). In one embodiment the polyimide dianhydride component (of the first outer layer polyimide base polymer and/or the second outer layer polyimide base polymer) is pyromellitic dianhydride ("PMDA") and the polyimide diamine component (of the first outer layer polyimide base polymer and/or the second outer layer polyimide base polymer) is a combination of 4,4'-oxydianiline ("4,4 ODA") and p-phenylenediamine ("PPD"), where the ratio of ODA to PPD (ODA:PPD) is any of the following mole ratios: i. 20-80: 80-20; ii. 50-70:50-30; or iii. 55-65: 45-35. In one embodiment the polyimide dianhydride component (of the first outer layer polyimide base polymer and/or the second outer layer polyimide base polymer) is PMDA, and the diamine component (of the first outer layer polyimide base polymer and/or the second outer layer polyimide base polymer) is a mole ratio of ODA to PPD (ODA:PPD) of about 58-62:38-42.

The first outer layer 12 comprises a first outer layer carbon black filler 20 interspersed in the first outer layer polyimide base polymer. In some embodiments, the first outer layer carbon black filler of the first outer layer 12 can be any carbon black, such as, any furnace black, acetylene black, bone black, channel type black and/or the like, depending upon the particular embodiment chosen. A low conductivity carbon black generally maintains good dielectric properties, while a high conductivity carbon black increases the conductivity of the material. Either will provide a black appearance to the first outer layer 12 of the multilayer film. In some embodiments, the low conductivity carbon black is a highly surface oxidized carbon black.

One method for assessing the extent of surface oxidation (of the carbon black filler) is to measure the carbon black's volatile content. The volatile content can be measured by calculating weight loss when calcined at 950°C for 7 minutes. Generally speaking, a highly surface oxidized carbon black can be readily dispersed into a polyamic acid solution (polyimide precursor), which in turn can be imidized into a (well dispersed) filled polyimide base polymer of the present disclosure. It is thought that if the carbon black particles (aggregates) are not in contact with each other, then electron tunneling, electron hopping or other electron flow mechanism are generally suppressed, resulting in lower electrical conductivity.

In some embodiments, the first outer layer low conductivity carbon black filler has a volatile content greater than or equal to 5%, 7%, 9%, 10%, 11%, 13 or 14% (by weight). In one embodiment, the low conductivity carbon black filler is a channel type black. In another embodiment the first low conductivity carbon black filler is a channel type black having a volatile content greater than or equal to 5%, 7%, 9%, 10%, 11 %, 13 or 14% (by weight). In another embodiment, the first outer layer carbon black filler is a furnace black with a dibutyl phthalate (DBP) oil absorption less than 70 ml/100 g by ASTM D2414 and BET surface area of less than 100 m²/g by ASTM D6556. A uniform dispersion of isolated, individual particles (aggregates) not only provides low electrical conductivity with respect to the first outer layer 12 of the multilayer film but additionally produces a first outer layer 12 having uniform color intensity. In other embodiments, pigments, dyes or any other alternatives to carbon black colorant can be used to produce an outer layer having a color, other than black.

In some embodiments, the first outer layer carbon black filler 20 is present within a range between and optionally including any two of the following weight percentages: 1, 2, 3, 4, 5, 6, 7, 8, 9, 10, 11, 12, 13, 14 and 15 weight % based upon the total weight of the first outer layer 12. In some embodiments, the first outer layer carbon black filler is present in a range between and optionally including any two of the following: 1, 2, 3, 4, 5, 6, 7, 8, 9, 10, 11, 12, 13, 14 and 15 weight % based upon the total weight of the first outer layer 12. In some embodiments, the first outer layer carbon black filler is a low conductivity carbon black filler, such as, Special Black 4™ carbon black from Evonik Industries. As the filler loading increases, the film will tend to become more conductive even when a low conductivity carbon black filler is used. As the filler loading decreases, the intensity of the color and/or opacity will tend to decrease. In some embodiments the carbon black is milled. In some embodiments, the mean particle size (in the largest dimension) of the first outer layer carbon black filler is in a range between and including any two of the following sizes: 0.2, 0.3, 0.4, 0.5, 0.6, 0.7, 0.8, 0.9 and 1.0 microns.

The first outer layer 12 additionally comprises a first outer layer dielectric filler 22. The first outer layer dielectric filler 22 is present in a range between and optionally including any two of the following weight percentages: 0.1, 2, 4, 6, 8, 10, 12, 14, 16, 18, 20, 22, 24, 26, 28, 30, 32, 34, 36, 38 and 40 weight % based upon the total weight of the first outer layer 12. As the amount of dielectric filler increases, the film tends to become more brittle, making the film more difficult to handle during the manufacturing process. While lower amounts or concentrations of dielectric filler can provide films with better physical properties, the film thickness required to achieve desired opacity is generally increased. The dielectric filler is used to impart a matte (low gloss) appearance and to achieve the desired optical density (opacity) of the multilayer film. Larger particles can be effective in creating a matte surface due to an increase in surface roughness. In some embodiments, the mean particle size of the first outer layer dielectric filler is in a range between and optionally including any two of the following sizes (in at least one dimension and in some embodiments, in all dimensions): 0.01, 0.02, 0.05, 0.07, 0.1, 0.2, 0.3, 0.4, 0.5, 0.6, 0.7, 0.8, 0.9, 1.0, 2.0, 3.0 and 4.0 microns. In some embodiments, the first outer layer dielectric filler is milled. Generally accepted ranges for 60 degree gloss values are:

| | |
|---|---|
| <10 | flat |
| 10 - 70 | matte, satin, semi-gloss (various terms are used) |
| >70 | glossy. |

For the purpose of the present invention, a 60 degree gloss value of 50 or less is most preferred.

In some embodiments, the first outer layer dielectric filler is selected from, but not limited to, a group comprising: silicon dioxide, calcium carbonate, magnesium carbonate, magnesium calcium carbonate, calcium oxide, magnesium oxide, talc, magnesium silicates, aluminum silicates, magnesium aluminum silicates, calcium silicates, clay, mica, barium sulfate, boron nitride, aluminum nitride, barium titanate, strontium titanate, alumina trihydrate, calcium sulphate, aluminum hydroxide, magnesium hydroxide, huntite, basic magnesium carbonate, melamine polyphosphate, and mixtures thereof. In some embodiments, the first outer layer dielectric filler is aluminum oxide. In some embodiments, the first outer layer dielectric filler is Martoxid MZS-1 alumina from Albemarle Corp.

The first outer layer 12 generally provides a low gloss (e.g., matte black) appearance.

The first outer layer 12 can be prepared by any method well known in the art for making a filled polyimide layer. In one embodiment, a polyamic acid solvent is used to dissolve one or both of the polymerizing reactants and in one embodiment, will dissolve the polyamic acid polymerization product. The solvent should be substantially unreactive with all of the polymerizing reactants and with the polyamic acid polymerization product.

In one embodiment the polyamic acid solvent is a liquid N,N-dialkylcarboxylamide, such as, a lower molecular weight carboxylamide, particularly N,N-dimethylformamide and N,N-diethylacetamide. Other useful compounds of this class of solvents are N,N-diethylformamide and N,N-diethylacetamide. Other solvents which may be used are diamethylsulfoxide, N-methyl-2-pyrrolidone, tetramethyl urea, dimethylsulfone, and the like. The solvents can be used alone or in combinations with one another. The amount of solvent used can range from 75 to 90 weight % of the polyamic acid, since this concentration has been found to give useful polymer molecular weights.

The polyamic acid solutions are generally made by dissolving the diamine in a dry solvent and slowly adding the dianhydride under conditions of agitation and controlled temperature in an inert atmosphere. The diamine is generally present as a 5 to 15 weight percent solution in the solvent and the diamine and dianhydride are usually used in about equimolar amounts.

In one embodiment, the first outer layer is created by: i. preparing a slurry comprising a low conductivity carbon black, dielectric filler and a polyamic acid to create a polyamic acid solution, and ii. then imidizing the polyamic acid of the polyamic acid solution to provide a carbon black and dielectric filler filled polyimide. In one embodiment, the carbon black is incorporated into the polyamic acid solution by means of a solvent carrier (for example, dimethylacetamide "DMAC"). In some embodiments, the carbon black slurry is mixed in a rotor stator, high-speed dispersion mill. In some embodiments, the carbon black slurry is milled until the desired particle size is achieved. In some embodiments a ball mill is used. In some embodiments, the milled carbon black slurry is filtered to remove any unwanted residual large particles. The carbon black slurry may be stored in a tank equipped with a mixer to maintain the dispersion until the slurry is ready to be used or the slurry may be used directly after milling.

A dielectric filler slurry comprising dielectric filler can be prepared in the same manner as the low conductivity carbon black slurry. In one embodiment, the dielectric filler slurry is milled using a ball mill to reach the desired particle size. The dielectric filler slurry can be used directly or stored in a tank equipped with a mixer to maintain the dispersion until it is ready to be used. In some embodiments, the milled dielectric filler slurry is filtered to remove any residual large particles. In some embodiments, the dielectric filler slurry is continuously recirculated through filters to remove any residual large particles or agglomerates.

The polyamic acid solution can be made by methods well known in the art. The polyamic acid solution may or may not be filtered. In some embodiments, the solution is mixed in a high shear mixer with the carbon black slurry and the dielectric filler slurry, and then a film of the mixture is cast onto a belt. A small amount of a belt release agent may be added to enable the cast film to be readily stripped from a casting belt. The amount of the polymer, carbon black slurry, dielectric filler slurry and finishing solution can be adjusted to achieve the desired loading levels of carbon black, dielectric filler and the desired viscosity for film formation. The film can then be chemically and/or thermally imidized into a carbon black, dielectric filler filled polyimide first outer layer. The first outer layer can be bonded directly to the core layer, such as by lamination or coextrusion, (or indirect contact by means of an adhesive) with the core layer.

The multilayer film 10 comprises a core layer 14 bonded between the first outer layer 12 and a second outer layer 16. The core layer allows the multilayer film to maintain acceptable mechanical and electrical properties. In one embodiment, at least 90, 95, 96, 97, 98, 99 or 100 weight percent of the core layer is a core layer polyimide base polymer. The core layer helps maintain high dielectric strength of the multilayer film. In some embodiments, the core layer polyimide base polymer is the same as the first outer layer polyimide base polymer. In some embodiments, the core layer polyimide base polymer is the different from the first outer layer polyimide base polymer. In some embodiments, the core layer polyimide base polymer is derived from at least one aromatic dianhydride and at least one aromatic diamine. In some embodiments, the aromatic diamine is selected from a group consisting of 3,4'- oxydianiline (3,4'-ODA), 1,3-bis-(4-aminophenoxy) benzene (APB-134 or RODA), 4,4'-oxydianiline (4,4'-ODA), 1,4-diaminobenzene (PPD), 1,3-diaminobenzene (MPD), 2,2'-bis(trifluoromethyl) benzidene (TFMB), 4,4'-diaminobiphenyl, 4,4'-diaminodiphenyl sulfide, 9,9'-bis(4-amino)fluorene and mixtures thereof. In some embodiments, the aromatic dianhydride is selected from a group consisting of pyromellitic dianhydride (PMDA), 3,3',4,4'-biphenyl tetracarboxylic dianhydride (BPDA), 3,3',4,4'-benzophenone tetracarboxylic dianhydride (BTDA); 4,4'-oxydiphthalic anhydride (ODPA), 3,3',4,4'-diphenyl sulfone tetracarboxylic dianhydride (DSDA), 2,2-bis(3,4-dicarboxyphenyl) hexafluoropropane and mixtures thereof. In another embodiment, the core layer polyimide base polymer is derived from pyromellitic dianhydride and 4,4'-oxydianiline.

The thickness of the core layer can be dependant on the desired tear strength, tensile strength and dielectric strength of the multilayer film. The thickness can be increased to provide better mechanical and electrical properties, but manufacturers generally desire increasingly thinner films. In some embodiments, the core layer is about one third of the total thickness of the multilayer film.

In one embodiment, the core layer optionally has a higher electrical resistivity by at least 25, 50, 100, 1000, 10,000 or 100,000 percent (based upon ohms per square of surface resistivity) compared to either the first outer layer 12 or the second outer layer 16.

The second outer layer 16 can be in direct contact, such as by lamination or coextrusion, (or indirect contact by means of an adhesive) with the core layer on the opposite side of the core layer from the first outer layer 12. The second outer layer 16 comprises a second outer layer polyimide base polymer present in a range between and optionally including any two of the following weight percentages: 45, 50, 55, 60, 65, 70, 75, 80, 85, 90, 95 and 98.9 weight % based on the total weight of the second outer layer 16. In one embodiment, the second outer layer polyimide base polymer is defined identically as the first outer layer polyimide base polymer, and the first outer layer base polymer and second outer layer base polymer can be the same or different. In some embodiments, the second outer layer polyimide base polymer is derived from at least one aromatic dianhydride and at least one aromatic diamine.

In one embodiment, the second outer layer polyimide base polymer is derived from one or more aromatic dianhydrides, such as:
1. 2,2-bis(3,4-dicarboxyphenyl) hexafluoropropane;
2. 2,3,6,7-naphthalene tetracarboxylic dianhydride;
3. 3,3',4,4'-biphenyl tetracarboxylic dianhydride;
4. 1,2,5,6-naphthalene tetracarboxylic dianhydride;
5. 2,2',3,3'-biphenyl tetracarboxylic dianhydride;
6. 3,3',4,4'-benzophenone tetracarboxylic dianhydride;
7. 2,2-bis(3,4-dicarboxyphenyl) propane dianhydride;
8. bis(3,4-dicarboxyphenyl) sulfone dianhydride;
9. 3,4,9,10-perylene tetracarboxylic dianhydride;
10. bis(3,4-dicarboxyphenyl) propane dianhydride;
11. 1,1-bis(2,3-dicarboxyphenyl) ethane dianhydride;
12. 1,1-bis(3,4-dicarboxyphenyl) ethane dianhydride;
13. bis(2,3-dicarboxyphenyl) methane dianhydride;
14. bis(3,4-dicarboxyphenyl) methane dianhydride;
15. 4,4'-oxydiphthalic dianhydride;
16. bis(3,4-dicarboxyphenyl) sulfone dianhydride; and
17. mixtures thereof.

In another embodiment, the second outer layer polyimide base polymer is optionally derived from one or more aliphatic dianhydrides, such as:
1. cyclobutane dianhydride,
2. [1S*,5R*,6S*]-3-oxabicyclo[3.2.1]octane-2,4-dione-6-spiro-3-(tetrahydrofuran- 2,5-dione); and
3. mixtures thereof.

Suitable diamines for use in the synthesis of the second outer layer polyimide base polymer of the present disclosure include aromatic diamines, aliphatic diamines and mixtures thereof. Examples of aromatic diamines include:
1. 4,4'-diaminodiphenyl propane;
2. 4,4'-diamino diphenyl methane;
3. benzidine;
4. 3,3'-dichlorobenzidine;
4. 4,4'-diamino diphenyl sulfide;
5. 3,3'-diamino diphenyl sulfone;
6. 4,4'-diamino diphenyl sulfone;
7. 1,5-diamino naphthalene;
8. 4,4'-diamino diphenyl diethylsilane;
9. 4,4'-diamino diphenysilane;
10. 4,4'-diamino diphenyl ethyl phosphine oxide;
11. 4,4'-diamino diphenyl N-methyl amine;
12. 4,4'-diamino diphenyl N-phenyl amine;
13. 1,4-diaminobenzene (p-phenylene diamine);
14. 1,3-diaminobenzene;
15. 1,2-diaminobenzene;
16. 1,3-bis-(4-aminophenoxy) benzene;
17. 3,4' diamino diphenyl ether;
18. 2,2'-bis(trifluoromethyl) benzidene;
19. 4,4'-diaminobiphenyl;
20. 9,9'-bis(4-amino)fluorene and
21. mixtures thereof.

Examples of suitable aliphatic diamines include:
1. hexamethylene diamine,
2. dodecane diamine,
3. cyclohexane diamine, and
4. mixtures thereof.

In one embodiment, the second outer layer polyimide base polymer of the present disclosure is a copolyimide derived from any of the above diamines and dianhydrides. In one embodiment, the copolyimide is derived from 15 to 85 mole % of biphenyltetracarboxylic dianhydride, 15 to 85 mole % pyromellitic dianhydride, 30 to 100 mole % p-phenylenediamine and 0 to 70 mole % of 4,4'-diaminodiphenyl ether. In some embodiments, the first outer layer polyimide base polymer and the second outer layer polyimide base polymer are both derived from at least one aromatic dianhydride and at least one aromatic diamine. In some embodiments, the first outer layer polyimide base polymer and the second outer layer polyimide base polymer comprise at least one polyimide polymer that is the same. In another embodiment, the first outer layer polyimide base polymer and the second outer layer polyimide base polymer are different. In yet another embodiment, the first outer layer polyimide base polymer, the second outer layer polyimide base polymer and core layer polyimide base polymer comprise at least one polyimide polymer that is the same. In some embodiments, the first outer layer polyimide base polymer and the second outer layer polyimide base polymer are derived from pyromellitic dianhydride and 4,4'-oxydianiline.

In an alternatve embodiment, the first outer layer, the core layer and/or the second outer layer may comprise (as an alternative to the first outer layer polyimide base polymer, core layer polyimide base polymer and/or the second outer layer polyimide base polymer, respectively) a member of a group comprising, but not limited to, polyesters, liquid crystalline polymers, fluoropolymers, polyetherketones, polyetheretherketones, polyetherketoneketones, polyamides, polyaramides, polysulfonamides and derivatives or combinations thereof. In such an alternative embodiment, the core layer is selected from a group comprising, but not limited to, polyesters, liquid crystalline polymers, fluoropolymers, polyetherketones, polyetheretherketones, polyetherketoneketones, polyamides, polyaramides, polysulfonamides and derivatives and combinations thereof. In such an alternative embodiment, dielectric polymers having high temperature stability are generally more desirable, since they are generally better able to withstand the high processing temperatures used to produce electronic components.

The second outer layer 16 comprises a second outer layer low conductivity carbon black filler 24 which is a low conductivity carbon black filler. In some embodiments, the second outer layer low conductivity carbon black filler has a volatile content greater than or equal to 5, 7, 9, 10, 11, 13 or 14 weight %. In one embodiment, the second outer layer low conductivity carbon black filler is a low conductivity channel type black. In another embodiment, the second outer layer low conductivity carbon black filler is a low conductivity channel type black having a volatile content greater than or equal to 5, 7, 9, 10, 11, 13 or 14 weight %. In another embodiment, the second outer layer low conductivity carbon black filler is a low conductivity furnace black with a dibutyl phthalate (DBP) oil absorption less than 70 ml/100 g by ASTM D2414 and BET surface area of less than 100 m²/g by ASTM D6556. In some embodiments, the second outer layer low conductivity carbon black filler is Special Black 4, from Evonik Degussa, GmbH, Essen, Germany. The second outer layer low conductivity carbon black filler 24 can be present in a range between and optionally including any two of the following weight percentages: 1, 2, 3, 4, 5, 6, 7, 8, 9, 10, 11, 12, 13, 14 and 15 weight % based upon the total weight of the second outer layer 16. In some embodiments, the mean particle size of the second outer layer low conductivity carbon black filler is within a range between and including any two of the following sizes (in at least one dimension and in some embodiments, in all dimensions): 0.01, 0.02, 0.05, 0.07, 0.1, 0.2, 0.3, 0.4, 0.5, 0.6, 0.7, 0.8, 0.9 and 1.0 microns. In some embodiments, the multilayer film first outer layer carbon black filler and the second outer layer low conductivity carbon black filler are both a channel type black having a volatile content greater than or equal to 13%.

The second outer layer 16 additionally comprises a second outer layer dielectric filler. The second outer layer dielectric filler may or may not be the same as the first outer layer dielectric filler. The second outer layer dielectric filler is present in a range between and optionally including any two of the following weight percentages: 0.1, 2, 4, 6, 8, 10, 12, 14, 16, 18, 20, 22, 24, 26, 28, 30, 32, 34, 36, 38 and 40 weight % based upon the total weight of the second outer layer 16. In some embodiments, the mean particle size of the second outer layer dielectric filler is in a range between and optionally including any two of the following sizes (in at least one dimension and in some embodiments, in all dimensions): 0.01, 0.02, 0.05, 0.07, 0.1, 0.2, 0.3, 0.4, 0.5, 0.6, 0.7, 0.8, 0.9, 1.0, 2.0, 3.0 and 4.0 microns. In some embodiments, the second outer layer dielectric filler is selected from, but not limited to, a group comprising: silicon dioxide, calcium carbonate, magnesium carbonate, magnesium calcium carbonate, calcium oxide, magnesium oxide, talc, magnesium silicates, aluminum silicates, magnesium aluminum silicates, calcium silicates, clay, mica, barium sulfate, boron nitride, aluminum nitride, barium titanate, strontium titanate, alumina trihydrate, calcium sulphate, aluminum hydroxide, magnesium hydroxide, huntite, basic magnesium carbonate , melamine polyphosphate, and mixtures thereof. In some embodiments, particularly effective second outer layer dielectric filler is aluminum oxide. In some embodiments, the second outer layer dielectric filler is Martoxid MZS-1 alumina from Albemarle Corp. In some embodiments, the multilayer film first outer layer dielectric filler and the second outer layer dielectric filler is aluminum oxide.

The second outer layer 16 may be prepared in the same manner as the first outer layer 12. The first and second outer layer of the multilayer film generally imparts the multilayer film with an optical density greater than or equal to 2. An optical density of 2 is intended to mean 1x10 ⁻² or 1% of light is transmitted through the film. In some embodiments, the optical density of the multilayer film is greater than or equal to 3.

In one embodiment, the first outer layer polyimide base polymer and the second outer layer polyimide base polymer comprise at least one polyimide polymer that is the same. In another embodiment, the first outer layer polyimide base polymer, the second outer layer polyimide base polymer and the polyimide of the core layer comprise at least one polyimide polymer that is the same. In some embodiments, the first outer layer polyimide base polymer and the second outer layer polyimide base polymer are both derived from at least one aromatic dianhydride and at least one aromatic diamine.

In some embodiments, the second outer layer 16 of the multilayer film 10 is bonded to a circuit board by an adhesive layer 18. In one embodiment, the adhesive consists of an epoxy resin and hardener, and, optionally, further contains additional components, such as, an elastomer reinforcing agent, curing accelerator, filler and flame retardant.

In some embodiments, the adhesive layer is an epoxy resin selected from the group consisting of bisphenol F type epoxy resin, bisphenol S type epoxy resin, phenol novolac type epoxy resin, biphenyl type epoxy resin, biphenyl aralkyl type epoxy resin, aralkyl type epoxy resin, dicyclopetadiene type epoxy resin, multifunctional type epoxy resin, naphthalene type epoxy resin, rubber modified epoxy resin, and mixtures thereof. In some embodiments, the adhesive layer is an epoxy resin selected from the group consisting of bisphenol A type epoxy resin, phosphorus containing epoxy resin and cresol novolac type epoxy resin. In some embodiments, the epoxy adhesive contains a hardener. In one embodiment, the hardener is a phenolic compound. In some embodiments, the phenolic compound is selected from the group consisting of:
Aralkyl type phenol resin,
Biphenyl aralkyl type phenol resin,
Multifunctional type phenol resin,
Nitrogen containing phenol resin,
Dicyclopetadiene type phenol resin,
Triazine containing phenol novolac resin, and
Phosphorus containing phenol resin.
In some embodiments, the hardener is selected from the group consisting of novolac phenol type, triazine containing phenol novolac type, 4,4'-diaminodiphenyl sulfone and mixtures thereof. In some embodiments, 4,4'-diaminodiphenyl sulfone can function as both hardener and catalyst. In another embodiment, the hardener is an aromatic diamine compound. In some embodiments, the aromatic diamine compound is a diaminobiphenyl compound. In some embodiments, the diaminobiphenyl compound is 4,4'-diaminobiphenyl or 4,4'-diamino-2,2'-dimethylbiphenyl. In some embodiments, the aromatic diamine compound is a diaminodiphenylalkane compound. In some embodiments, the diaminodiphenylalkane compound is 4,4'-diaminodiphenylmethane or 4,4'-diaminodiphenylethane. In some embodiments, the aromatic diamine compound is a diaminodiphenyl ether compound. In some embodiments, the diaminodiphenyl ether compounds is 4,4'-diaminodiphenylether or di(4-amino-3-ethylphenyl)ether. In some embodiments, the aromatic diamine compound is a diaminodiphenyl thioether compound. In some embodiments, the diaminodiphenyl thioether compound is 4,4'-diaminodiphenyl thioether or di(4-amino-3-propylphenyl)thioether. In some embodiments, the aromatic diamine compound is a diaminodiphenyl sulfone compound. In some embodiments, the diaminodiphenyl sulfone compound is 4,4'-diaminodiphenyl sulfone or di(4-amino-3-isopropylphenyl)sulfone. In some embodiments, the aromatic diamine compound is phenylenediamine. In one embodiment, the hardener is an amine compound. In some embodiments, the amine compound is a guanidine. In some embodiments, the guanidine is dicyandiamide (DICY). In another embodiment, the amine compound is an aliphatic diamine. In some embodiments, the aliphatic diamine is ethylenediamine or diethylenediamine.

In some embodiments, the epoxy adhesive contains a catalyst. In some embodiments, the catalyst is selected from the group consisting of imidazole type, triazine type, 2-ethyl-4-methyl-imidazole, triazine containing phenol novolac type and mixtures thereof.

In some embodiments, the epoxy adhesive contains a elastomer reinforcing agent. In some embodiments, the elastic reinforcing agent is selected from the croup consisting of ethylene-acryl rubber, acrylonitrile-butadiene rubber, carboxy terminated acrylonitrile-butadiene rubber and mixtures thereof. In some embodiments, the epoxy adhesive contains a flame retardant. In some embodiments, the flame retardant is selected from the group consisting of aluminum trihydroxide, melamine polyphosphate, condensed polyphosphate ester, other phosphorus containing flame retardants and mixtures thereof.

In some embodiments, the adhesive layer is selected from the group consisting of polyimide, butyral phenolic, polysiloxane, polyimidesiloxane, fluorinated ethylene propylene copolymer (Teflon FEP), perfluoroalkoxy copolymer (Teflon PFA),ethylene vinyl acetate copolymer with adhesion promotor, ethylene vinyl acetate glycidyl acrylate terpolymer, ethylene vinyl acetate glycidyl methacrylate terpolymer, ethylene alkyl acrylate copolymers with adhesion promotor, ethylene alkyl methacrylate copolymers with adhesion promotor, ethylene glycidyl acrylate, ethylene glycidyl methacrylate, ethylene alkyl acrylate glycidyl acrylate terpolymer, ethylene alkyl methacrylate glycidyl acrylate terpolymer, ethylene alkyl acrylate maleic anhydride terpolymers, ethylene alkyl methacrylate maleic anhydride terpolymers, ethylene alkyl acrylate glycidyl methacrylate terpolymers, ethylene alkyl methacrylate glycidyl methacrylate terpolymers, alkyl acrylate acrylonitrile acrylic acid terpolymers, alkyl acrylate acrylonitrile methacrylic acid terpolymers, ethylene acrylic acid copolymer including salts thereof, ethylene methacrylic acid copolymer including salts thereof, alkyl acrylate acrylonitrile glycidyl methacrylate terpolymers, alkyl methacrylate acrylonitrile glycidyl methacrylate terpolymers, alkyl acrylate acrylonitrile glycidyl acrylate terpolymers, alkyl methacrylate acrylonitrile glycidyl acrylate terpolymers, polyvinyl butyral, ethylene alkyl acrylate methacrylic acid terpolymers including salts thereof, ethylene alkyl methacrylate methacrylic acid terpolymers including salts thereof, ethylene alkyl acrylate acrylic acid terpolymers including salts thereof ethylene alkyl methacrylate acrylic acid terpolymers including salts thereof, ethylene ethyl hydrogen maleate, ethylene alkyl acrylate ethyl hydrogen maleate, ethylene alkyl methacrylate ethyl hydrogen maleate, and derivative and mixtures thereof.

One advantage of a three layer structure (verses a two layer structure) is a three layer film inhibits unwanted curl. In one embodiment the multilayer film meets UL94V0 standardized flammability test.

In some embodiments, the multilayer film has a thickness in a range between and optionally including any two of the following thicknesses (in microns): 6, 8, 10, 12, 14, 16, 18, 20, 25, 30, 35, 40, 45 and 50 microns. In some embodiments, the multilayer film of the present disclosure is a direct replacement of conventional coverlayers.

In some embodiments, the multilayer film has a direct current ("D.C.") dielectric strength greater than or equal to 2000 V/mil. In some embodiments, the multilayer film has a D.C dielectric strength greater than or equal to 3000 V/mil. In some embodiments, the multilayer film has a D.C dielectric strength greater than or equal to 5000 V/mil. In some embodiments, the multilayer film has a D.C. dielectric strength greater than or equal to 7000 V/mil. In some embodiments, the multilayer film has a D.C dielectric strength greater than or equal to 9000 V/mil.

In some embodiments, the multilayer film has a surface resistivity equal to or greater than 8.00 ohms/square x 10¹⁵ at 1000V. In some embodiments, the multilayer film has a surface resistivity equal to or greater than 9.00 ohms/square x 10¹⁵ at 1000V.

In some embodiments, the multilayer film has a surface resistivity equal to or greater than 10.00 ohms/square x 10¹⁵ at 1000V. In some embodiments, the multilayer film has a surface resistivity equal to or greater than 11.00 ohms/square x 10¹⁵ at 1000V. In some embodiments, the multilayer film has a surface resistivity equal to or greater than 12.00 ohms/square x 10¹⁵ at 1000V. Surface resistivity according to the present disclosure is measured using a Advantest Model R8340 ultra high resistance meter with a UR type concentric ring probe and is measured at 1000 volts.

In one embodiment, the multiple polymeric layers of the present disclosure can be prepared as a multilayer composite either by laminating single layers together with or without a separate adhesive or by coextrusion processes to prepare multilayer films, or by combinations of these. A description of a coextrusion process for preparing multilayer polyimide films is provided in EP 0659553 A1 to Sutton et al.

In some embodiments, a finished polyamic acid /low conductivity carbon black filler/ dielectric filler solution is filtered and pumped to a slot die, where the flow is divided in such a manner as to form the first outer layer and the second outer layer of a three-layer coextruded film. In some embodiments, a second stream of polyimide is filtered, then pumped to a casting die, in such a manner as to form the middle, unfilled polyimide core layer of a three-layer coextruded film of the present disclosure. The flow rates of the solutions can be adjusted to achieve the desired layer thickness.

In some embodiments, the multilayer film is prepared by simultaneously extruding the first outer layer, the core layer and the second outer layer. In some embodiments, the layers are extruded through a single or multi-cavity extrusion die. In another embodiment, the multilayer film is produced using a single-cavity die. If a single-cavity die is used, the laminar flow of the streams should be of high enough viscosity to prevent comingling of the streams and to provide even layering. In some embodiments, the multilayer film is prepared by casting from the slot die onto a moving stainless steel belt. In one embodiment, the belt is then passed through a convective oven, to evaporate solvent and partially imidize the polymer, to produce a "green" film. The green film can be stripped off the casting belt and wound up. The green film can then be passed through a tenter oven to produce a fully cured polyimide film. In some embodiments, during tentering, shrinkage can be minimized by constraining the film along the edges (i.e. using clips or pins).

Although methods and materials similar or equivalent to those described herein can be used in the practice or testing of the present invention, suitable methods and materials are described herein.

When an amount, concentration, or other value or parameter is given as either a range, preferred range or a list of upper preferable values and lower preferable values, this is to be understood as specifically disclosing all ranges formed from any pair of any upper range limit or preferred value and any lower range limit or preferred value, regardless of whether ranges are separately disclosed. Where a range of numerical values is recited herein, unless otherwise stated, the range is intended to include the endpoints thereof, and all integers and fractions within the range. It is not intended that the scope of the invention be limited to the specific values recited when defining a range.

In describing certain polymers it should be understood that sometimes applicants are referring to the polymers by the monomers used to make them or the amounts of the monomers used to make them. While such a description may not include the specific nomenclature used to describe the final polymer or may not contain product-by-process terminology, any such reference to monomers and amounts should be interpreted to mean that the polymer is made from those monomers or that amount of the monomers, and the corresponding polymers and compositions thereof.

The materials, methods, and examples herein are illustrative only and, except as specifically stated, are not intended to be limiting.

As used herein, the terms "comprises," "comprising," "includes," "including," "has," "having" or any other variation thereof, are intended to cover a non-exclusive inclusion. For example, a method, process, article, or apparatus that comprises a list of elements is not necessarily limited only those elements but may include other elements not expressly listed or inherent to such method, process, article, or apparatus. Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

Also, use of the "a" or "an" are employed to describe elements and components of the invention. This is done merely for convenience and to give a general sense of the invention. This description should be read to include one or at least one and the singular also includes the plural unless it is obvious that it is meant otherwise.

### EXAMPLES

The invention will be further described in the following examples, which do not limit the scope of the invention described in the claims.

Optical density is measured with a X-Rite Model 301 optical densitometer. X-Rite, Inc., Grandville, MI.

60 degree gloss is measured with a Micro-TRI-Gloss gloss meter. Byk Gardner USA, Columbia, MD.

Surface resistivity is measured using a Advantest Model R8340 ultra high resistance meter with a UR type concentric ring probe and is measured at 1000 volts.

A carbon black slurry was prepared, consisting of 80 wt % DMAC, 10 wt % polyamic acid solution (20.6 wt % polyamic acid solids in DMAC), and 10 wt % low conductivity carbon black powder (Special Black 4, from Evonik Degussa). The ingredients were thoroughly mixed in a rotor stator, high-speed dispersion mill. The slurry was then processed in a ball mill until the desired particle size was achieved. The slurry was filtered and transferred to an agitated storage tank equipped with an in-line rotor stator mixer, in order to maintain the state of dispersion until the slurry was ready to be used. The mean particle size measurement on the slurry in the tank was 0.298 microns and was measured using a Horiba LA930 particle size analyzer.

An alumina slurry was prepared, consisting of 51.72 wt % DMAC, 24.14 wt % polyamic acid prepolymer solution (20.6 wt % polyamic acid solids in DMAC), and 24.14 wt % alpha alumina powder with median particle size of 2-3 microns. The ingredients were thoroughly mixed in a rotor stator, high-speed dispersion mill. The slurry was then milled in a ball mill to break down large agglomerates.

The slurry was transferred to an agitated storage tank until the slurry was ready to be used. While in the tank the slurry was also continuously recirculated through filters to remove any residual large particles or agglomerates.

A PMDA/4,4'ODA polyamic acid solution (20.6% polyamic acid solids, ∼50 Poise viscosity) was "finished" by mixing in a high shear mixer with a 5.8 wt % PMDA solution in DMAC, in order to increase molecular weight and the viscosity to approximately 1500 Poise. The finished solution was filtered and mixed in a high shear mixer with the low conductivity carbon black and alumina slurries, along with additional PMDA finishing solution, and a small amount of a belt release agent (which enables the cast green film to be readily stripped from the casting belt). The quantity of PMDA finishing solution was adjusted to achieve a viscosity of 1200 Poise. The relative amounts of the polymer, slurries, and finishing solution were adjusted in order to achieve the desired loading levels of low conductivity carbon black and alumina, and pressure at the casting die.

The finished polymer/slurry mixture was filtered and pumped to a slot die, where the flow was divided in such a manner as to form the first outer layer and the second outer layer of a three-layer coextruded film.

A second stream of PMDA/ODA polyamic acid polymer solution, which was finished in a high shear mixer to 1500 Poise viscosity and filtered, was pumped to the casting die to form the middle, unfilled polyimide core layer of a three-layer coextruded film. The flow rates of the first and second outer layers as well as the unfilled polyimide core layer solutions were adjusted in order to achieve the desired layer thickness.

A three-layer coextruded film was produced from the components described above by casting from the slot die onto a moving stainless steel belt. The belt passed into a convective oven, to evaporate solvent and partially imidize the polymer, to produce a "green" film. Green film solids (as measured by weight loss upon heating to 300°C) ranged from 72.6% to 74.8%. The green film was stripped off the casting belt and wound up. The green film was then passed through a tenter oven to produce a fully cured polyimide film. During tentering, shrinkage was controlled by constraining the film along the edges. Cured film solids (as measured by weight loss upon heating to 300°C) ranged from 98.8% to 99.1%.

The middle unfilled layer comprises about one third of the total thickness of the multilayer film. The first outer layer and the second outer layer were of about equal thickness, containing alumina and low conductivity carbon black fillers.

Examples 1 though 4 below were produced via the basic process described above. Results were shown in table 1.

**Table 1**

| **Ex.** | **Total Thickness** | **Green Solids** | **Cured Solids** | **Outer Layer Alumina Loading** | **Outer Layer Carbon Loading** | **Dielectric Strength DC** | **Optical Density** | **Gloss at 60 - Air** | **Surface Resistivity @ 1000V** |
|---|---|---|---|---|---|---|---|---|---|
| | **mil** | **%** | **%** | **%** | **%** | **V/mil** | | **gloss units** | ohms/square x 10¹⁵ |
| 1 | 0.69 | 74.22% | 99.05% | 28 | 6.5 | 8502 | 3.44 | 40.0 | 8.64 |
| 2 | 0.69 | 74.79% | 99.03% | 28 | 6.5 | 7778 | 3.40 | 38.8 | 8.13 |
| 3 | 0.49 | 73.08% | 98.83% | 28 | 6.5 | 7755 | 2.48 | 38.6 | 9.08 |
| 4 | 0.50 | 72.58% | 98.81% | 30 | 7.0 | 3711 | 2.87 | 27.4 | 11.4 |

Note that not all of the activities described above in the general description or the examples are required, that a portion of a specific activity may not be required, and that further activities may be performed in addition to those described. Still further, the order in which each of the activities are listed are not necessarily the order in which they are performed. After reading this specification, skilled artisans will be capable of determining what activities can be used for their specific needs or desires.

In the foregoing specification, the invention has been described with reference to specific embodiments. However, one of ordinary skill in the art appreciates that various modifications and changes can be made without departing from the scope of the invention as set forth in the claims below. All features disclosed in this specification may be replaced by alternative features serving the same, equivalent or similar purpose. Accordingly, the specification and figures are to be regarded in an illustrative rather than a restrictive sense and all such modifications are intended to be included within the scope of the invention.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims.

When an amount, concentration, or other value or parameter is given as either a range, preferred range or a list of upper values and lower values, this is to be understood as specifically disclosing all ranges formed from any pair of any upper range limit or preferred value and any lower range limit or preferred value, regardless of whether ranges are separately disclosed. Where a range of numerical values is recited herein, unless otherwise stated, the range is intended to include the endpoints thereof, and all integers and fractions within the range. It is not intended that the scope of the invention be limited to the specific values recited when defining a range.

## Claims

1. A multilayer film for electronic circuitry applications, comprising:
A. a first outer layer comprising:
i. a first outer layer base polymer in an amount from 45 to 98.9 weight % based upon a total weight of the first outer layer;
ii. a first outer layer carbon black filler in an amount from 1 to 15 weight % based upon the total weight of the first outer layer;
iii. a first outer layer dielectric filler in an amount from 0.1 to 40 weight % based upon the total weight of the first outer layer,
B. a core layer comprising a core layer base polymer, said core layer base polymer being present in an amount of at least 95 weight percent based upon a total weight of the core layer; and
C. a second outer layer comprising;
i. a second outer layer base polymer In an amount from 45 to 98.9 weight % based upon a total weight of the second outer layer;
ii. a second outer layer low conductivity carbon black filler in an amount from 1 to 15 weight % based upon the total weight of the second outer layer, wherein the low conductivity carbon black filler is a carbon black filler having a volatile content greater than or equal to 13% or a channel type black.
iii. a second outer layer dielectric filler in an amount from 0.1 to 40 weight % based upon the total weight of the second outer layer,
wherein:
a. the first outer layer base polymer,
b. the core layer base polymer, and
c. the second outer layer base polymer,
can each be the same or different and each comprise one or more members of the group consisting of: polyesters, polyimides, liquid crystalline polymers, fluoropolymers, polyetherketones, polyetheretherketones, polyetherketoneketones, polyamides, polyaramides, polysutfonamides and derivatives or combinations thereof;
wherein both the first outer layer dielectric filler and the second outer layer dielectric filler are selected from the group consisting of: silicon dioxide, calcium carbonate, magnesium carbonate, bone black, magnesium calcium carbonate, calcium oxide, magnesium oxide, silica, talc, magnesium silicates, aluminum silicates, magnesium aluminum silicates, calcium silicates, clay, mica, barium sulfate, boron nitride, aluminum nitride, barium titanate, strontium titanate, alumina trihydrate, calcium sulphate, aluminum hydroxide, magnesium hydroxide, huntite, basic magnesium carbonate, melamine polyphosphate, and mixtures thereof.
and wherein the multilayer film thickness is in a range from 6 to 200 microns.

2. A multilayer film in accordance with claim 1, wherein the first outer layer dielectric filler and the second outer layer dielectric filler is a member of the group consisting of aluminum oxide, silica and combinations thereof, wherein the first outer layer dielectric filler and the second outer layer dielectric filler are the same or different

3. A multilayer film In accordance with claim 1, wherein the first outer layer carbon black filler and the second outer layer low conductivity carbon black filler has a volatile content greater than or equal to 13 %.

4. A multilayer film in accordance with claim 1, wherein the first outer layer polyimide base polymer and the second outer layer polyimide base polymer comprise at least one polyimide polymer that is the same.

5. A multilayer film in accordance with claim 1, wherein the first outer layer polyimide base polymer, the second outer layer polyimide base polymer and the polyimide of the core layer comprise at least one polyimide polymer that is the same.

6. A multilayer film in accordance with claim 1, wherein the first outer layer polyimide base polymer and the second outer layer polyimide base polymer are both derived from at least one aromatic dianhydride and at least one aromatic diamine.

7. A multilayer film in accordance with claim 1, wherein the first outer layer polyimide base polymer Is derived from pyromellitic dianhydride and 4,4'-oxydianiline.

8. A multilayer film in accordance with claim 1, wherein the first outer layer polyimide base polymer and the second outer layer polyimide base polymer are derived from pyromellitic dianhydride and 4,4'-oxydianiline.

9. A multilayer film in accordance with claim 1, wherein the second outer layer is bonded to a circuit board by an adhesive layer.

10. A multilayer film in accordance with claim 1, wherein the mean particle size in one dimension of the first outer layer carbon black filler and second outer layer low conductivity carbon black filler is from 0.2 to 5 microns.

11. A multilayer film in accordance with claim 1, wherein the mean particle size of the first outer layer dielectric filler and the second outer layer dielectric filler is from 0.1 to 4.0 microns.

## Patentansprüche

1. Mehrschichtfilm für elektronische Schaltkreisanwendungen, umfassend:
A. eine erste Außenschicht umfassend:
i. ein erstes Außenschicht-Basispolymer in einer Menge von 45 bis 98,9 Gew.-%, auf ein Gesamtgewicht der ersten Außenschicht bezogen;
ii. einen ersten Außenschicht-Rußfüllstoff in einer Menge von 1 bis 15 Gew.-%, auf das Gesamtgewicht der ersten Außenschicht bezogen;
iii. einen ersten dielektrischen Außenschicht-Füllstoff in einer Menge von 0,1 bis 40 Gew.-%, auf das Gesamtgewicht der ersten Außenschicht bezogen;
B. eine Kernschicht umfassend ein Kernschicht-Basispolymer, wobei das Kernschicht-Basispolymer in einer Menge von mindestens 95 Gewichtsprozent, auf das Gesamtgewicht der Kernschicht bezogen, vorliegt; und
C. eine zweite Außenschicht umfassend:
i. ein zweites Außenschicht-Basispolymer einer Menge von 45 bis 98,9 Gew.-%, auf ein Gesamtgewicht der zweiten Außenschicht bezogen;
ii. einen zweiten Außenschicht-Rußfüllstoff niedriger Leitfähigkeit in einer Menge von 1 bis 15 Gew.-%, auf das Gesamtgewicht der zweiten Außenschicht bezogen; wobei der Rußfüllstoff niedriger Leitfähigkeit ein Rußfüllstoff, der einen Gehalt an flüchtigen Substanzen von mehr als oder gleich 13 % aufweist, oder ein Ruß vom Kanaltyp ist;
iii. einen zweiten dielektrischen Außenschicht-Füllstoff in einer Menge von 0,1 bis 40 Gew.-%, auf das Gesamtgewicht der zweiten Außenschicht bezogen;
wobei:
a. das erste Außenschicht-Basispolymer,
b. das Kernschicht-Basispolymer und
c. das zweite Außenschicht-Basispolymer
gleich oder verschieden sein können und jedes eine oder mehrere Teilnehmersubstanzen der Gruppe umfasst bestehend aus: Polyestern, Polyimiden, Flüssigkristallpolymeren, Fluorpolymeren, Polyetherketonen, Polyetheretherketonen, Polyetherketonketonen, Polyamiden, Polyaramiden, Polysulfonamiden und Derivaten oder Kombinationen davon;
wobei sowohl der erste dielektrische Außenschicht-Füllstoff als auch der zweite dielektrische Außenschicht-Füllstoff aus der Gruppe ausgewählt sind bestehend aus: Siliciumdioxid, Calciumcarbonat, Magnesiumcarbonat, Knochenkohle, Magnesium-Calciumcarbonat, Calciumoxid, Magnesiumoxid, Siliciumdioxid; Talkum, Magnesiumsilicaten, Aluminiumsilicaten, Magnesium-Aluminium-Silicaten, Calciumsilicaten, Ton, Glimmer, Bariumsulfat, Bornitrid, Aluminiumnitrid, Bariumtitanat, Strontiumtitanat, Aluminiumoxidtrihydrat, Calciumsulfat, Aluminiumhydroxid, Magnesiumhydroxid, Huntit, basischem Magnesiumcarbonat, Melaminpolyphosphat und Mischungen davon,
und wobei die Mehrschichtfilmdicke in einem Bereich von 6 bis 200 Mikron liegt.

2. Mehrschichtfilm nach Anspruch 1, wobei der erste dielektrische Außenschicht-Füllstoff und der zweite dielektrische Außenschicht-Füllstoff eine Teilnehmersubstanz der Gruppe sind bestehend aus Aluminiumoxid, Siliciumdioxid und Kombinationen davon, wobei der erste dielektrische Außenschicht-Füllstoff und der zweite dielektrische Außenschicht-Füllstoff gleich oder verschieden sind.

3. Mehrschichtfilm nach Anspruch 1, wobei der erste Außenschicht-Rußfüllstoff und der zweite Außenschicht-Rußfüllstoff niedriger Leitfähigkeit einen Gehalt an flüchtigen Substanzen aufweisen, der höher als oder gleich 13 % ist.

4. Mehrschichtfilm nach Anspruch 1, wobei das erste Außenschicht-Polyimidbasispolymer und das zweite Außenschicht-Polyimidbasispolymer mindestens ein Polyimidpolymer umfassen, das dasselbe ist.

5. Mehrschichtfilm nach Anspruch 1, wobei das erste Außenschicht-Polyimidbasispolymer, das zweite Außenschicht-Polyimidbasispolymer und das Polyimid der Kernschicht mindestens ein Polyimidpolymer umfassen, das dasselbe ist.

6. Mehrschichtfilm nach Anspruch 1, wobei das erste Außenschicht-Polyimidbasispolymer und das zweite Außenschicht-Polyimidbasispolymer beide von mindestens einem aromatischen Dianhydrid und mindestens einem aromatischen Diamin abgeleitet sind.

7. Mehrschichtfilm nach Anspruch 1, wobei das erste Außenschicht-Polyimidbasispolymer von Pyromellitsäuredianhydrid und 4,4'-Oxydianilin abgeleitet ist.

8. Mehrschichtfilm nach Anspruch 1, wobei das erste Außenschicht-Polyimidbasispolymer und das zweite Außenschicht-Polyimidbasispolymer von Pyromellitsäuredianhydrid und 4,4'-Oxydianilin abgeleitet sind.

9. Mehrschichtfilm nach Anspruch 1, wobei die zweite Außenschicht mit einer Klebstoffschicht an eine Leiterplatte bondiert ist.

10. Mehrschichtfilm nach Anspruch 1, wobei die mittlere Teilchengröße in einer Dimension des ersten Außenschicht-Rußfüllstoffs und des zweiten Außenschicht-Rußfüllstoffs niedriger Leitfähigkeit 0,2 bis 5 Mikron beträgt.

11. Mehrschichtfilm nach Anspruch 1, wobei die mittlere Teilchengröße des ersten dielektrischen Außenschicht-Rußfüllstoffs und des zweiten dielektrischen Außenschicht-Rußfüllstoffs 0,1 bis 4,0 Mikron beträgt.

## Revendications

1. Film multicouche pour applications de circuits électroniques, comprenant:
A. une première couche externe comprenant:
i. un polymère de base pour la première couche externe en une quantité de 45 à 98,9 % en poids sur la base d'un poids total de la première couche externe;
ii. une charge noir de carbone pour la première couche externe en une quantité de 1 à 15 % en poids sur la base du poids total de la première couche externe,
iii. une charge diélectrique pour la première couche externe en une quantité de 0,1 à 40 % en poids sur la base du poids total de la première couche externe,
B. une couche noyau comprenant un polymère de base pour la couche noyau, ledit polymère de base pour la couche noyau étant présent en une quantité d'au moins 95 pour cent en poids sur la base d'un poids total de la couche noyau; et
C. une seconde couche externe comprenant;
i. un polymère de base pour la seconde couche externe en une quantité de 45 à 98,9 % en poids sur la base d'un poids total de la seconde couche externe;
ii. une charge noir de carbone de faible conductivité pour la seconde couche externe en une quantité de 1 à 15 % en poids sur la base du poids total de la seconde couche externe; où la charge noir de carbone de faible conductivité est une charge noir de carbone ayant une teneur en substances volatiles supérieure ou égale à 13 % ou un noir de type à canaux.
iii. une charge diélectrique pour la seconde couche externe en une quantité de 0,1 à 40 % en poids sur la base du poids total de la seconde couche externe;
dans laquelle:
a. le polymère de base pour la première couche externe,
b. le polymère de base pour la couche noyau, et
c. le polymère de base pour la seconde couche externe,
peuvent chacun être identiques ou différents et comprennent chacun un ou plusieurs membre(s) du groupe constitué des: polyesters, polyimides, polymères cristallins liquides, polymères fluorés, polyéthercétones, polyétheréthercétones, polyéthercétonecétones, polyamides, polyaramides, polysulfonamides et leurs dérivés ou combinaisons;
où à la fois la charge diélectrique pour la première couche externe et la charge diélectrique pour la seconde couche externe sont sélectionnées parmi le groupe constitué: du dioxyde de silicium, du carbonate de calcium, du carbonate de magnésium, du noir d'os, du carbonate de magnésium calcium, de l'oxyde de calcium, de l'oxyde de magnésium, de la silice, du talc, des silicates de magnésium, des silicates d'aluminium, des silicates de magnésium aluminium, des silicates de calcium, de l'argile, du mica, du sulfate de baryum, du nitrure de bore, du nitrure d'aluminium, du titanate de baryum, du titanate de strontium, de l'alumine trihydratée, du sulfate de calcium, de l'hydroxyde d'aluminium, de l'hydroxyde de magnésium, de l'huntite, du carbonate de magnésium basique, du polyphosphate de mélamine, et de leurs mélanges,
et où l'épaisseur du film multicouche se situe dans une plage de 6 à 200 microns.

2. Film multicouche selon la revendication 1, dans lequel la charge diélectrique pour la première couche externe et la charge diélectrique pour la seconde couche externe sont un membre du groupe constitué de l'oxyde d'aluminium, de la silice et de leurs combinaisons, où la charge diélectrique pour la première couche externe et la charge diélectrique pour la seconde couche externe sont identiques ou différentes.

3. Film multicouche selon la revendication 1, dans lequel la charge noir de carbone pour la première couche externe et la charge noir de carbone de faible conductivité pour la seconde couche externe présentent une teneur en substances volatiles supérieure ou égale à 13 %.

4. Film multicouche selon la revendication 1, dans lequel le polymère de base de polyimide pour la première couche externe et le polymère de base de polyimide pour la seconde couche externe comprennent au moins un polymère de polyimide qui est identique.

5. Film multicouche selon la revendication 1, dans lequel le polymère de base de polyimide pour la première couche externe, le polymère de base de polyimide pour la seconde couche externe et le polyimide de la couche noyau comprennent au moins un polymère de polyimide qui est identique.

6. Film multicouche selon la revendication 1, dans lequel le polymère de base de polyimide pour la première couche externe et le polymère de base de polyimide pour la seconde couche externe sont tous les deux dérivés d'au moins un dianhydride aromatique et d'au moins une diamine aromatique.

7. Film multicouche selon la revendication 1, dans lequel le polymère de base de polyimide pour la première couche externe est dérivé du dianhydride pyromellitique et de la 4,4'-oxydianiline.

8. Film multicouche selon la revendication 1, dans lequel le polymère de base de polyimide pour la première couche externe et le polymère de base de polyimide pour la seconde couche externe sont dérivés du dianhydride pyromellitique et de la 4,4'-oxydianiline.

9. Film multicouche selon la revendication 1, dans lequel la seconde couche externe est liée à une carte de circuits imprimés grâce à une couche adhésive.

10. Film multicouche selon la revendication 1, dans lequel la taille moyenne des particules en une dimension de la charge noir de carbone pour la première couche externe et pour la charge noir de carbone de faible conductivité pour la seconde couche externe est de 0,2 à 5 micron(s).

11. Film multicouche selon la revendication 1, dans lequel la taille moyenne des particules de la charge diélectrique pour la première couche externe et pour la charge diélectrique pour la seconde couche externe est de 0,1 à 4,0 micron(s).
